# EUROPEAN PATENT APPLICATION

(11) **EP 4 763 516 A1**
(43) Date of publication of application: **24.06.2026**
(21) Application number: 24854161.7
(22) Date of filing: 08.08.2024
(51) Int. Cl.: B32B 27/34, B32B 9/00, C08G 73/10, H01L 21/312

(54) **LAMINATE**

(30) Priority: 15.08.2023 JP 2023132314
(71) Applicant: MITSUBISHI GAS CHEMICAL COMPANY, INC., Chiyoda-ku Tokyo 100-8324 (JP)
(72) Inventor: ABIKO Yohei, Hiratsuka-shi, Kanagawa 254-0016 (JP); OKADA Kana, Hiratsuka-shi, Kanagawa 254-0016 (JP); YASUFUKU Haruka, Hiratsuka-shi, Kanagawa 254-0016 (JP); ISHII Kentaro, Hiratsuka-shi, Kanagawa 254-0016 (JP); YONEHAMA Shinichi, Hiratsuka-shi, Kanagawa 254-0016 (JP)
(74) Representative: Hoffmann Eitle
(86) International application number: PCT/JP2024/028363
(87) International publication number: WO 2025/037571

(57) **Abstract**

Provided is a laminate including a support substrate and a polyimide resin layer on the support substrate, the support substrate including a step, in which a polyimide resin constituting the polyimide resin layer has a structural unit of General Formula (1) below and has a glass transition temperature of 300°C or higher. Also provided is a method for producing a laminate, which includes a step of obtaining a polyimide resin layer by applying a varnish of a polyimide resin or a varnish of a polyimide resin precursor onto a support substrate including a step and heating, in which the polyimide resin or the polyimide resin precursor has a structural unit of General Formula (1) below:

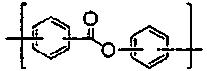

## Description

### Technical Field

The present invention relates to a laminate and a method for producing the laminate.

### Background Art

As high integration of semiconductors advances, it is important to planarize an insulating film on a wafer surface in a semiconductor process to improve patterning accuracy in high definition, miniaturization, and multilayering of wirings and to improve accuracy of bonding wafers to each other.

Polyimide resins have excellent mechanical properties, thermal resistance, and insulating properties. Thus, various applications of polyimide resins have been studied in the fields of electric and electronic components and the like, and attempts have also been made to use polyimide resins as the insulating film.

For example, Patent Document 1 discloses a planarization process for forming an insulating film by applying a composition containing a fully imidized polyimide polymer and a solvent onto a substrate having a conductive metal pattern for the purpose of forming an insulating film having good planarization characteristics.

### Citation List

### Patent Document

Patent Document 1: JP 2022-550611 A

### Summary of Invention

### Technical Problem

The polyimide resin has excellent properties as described above, but has several issues when it is used as a material for an insulating film in the semiconductor field, in particular, a material for a planarization film.

For example, a silicon wafer or the like used in the semiconductor field has few functional groups on the surface, and hardly exhibits adhesion to a resin and step embedding properties. In addition, in the planarization (polishing) process, a polishing liquid is used, but there has been a concern that the adhesive force of the resin is reduced particularly because of water absorption or the like, and the thermal resistance deteriorates.

Further, it has been very difficult to simultaneously satisfy all of these performances. For example, when the fluidity of the resin is increased to improve planarization characteristics, embedding properties, adhesion, and the like, thermal resistance deteriorates.

The present invention has been made in view of such circumstances, and an object of the present invention is to provide a laminate excellent in thermal resistance, adhesion, step embedding properties, and flatness.

### Solution to Problem

The inventors of the present invention have found that the object can be achieved by a laminate including a polyimide resin layer having a specific structural unit on a support substrate which includes a step, the polyimide resin layer having a glass transition temperature of 300°C or higher, and thus completed the present invention.

That is, the present invention relates to the following [1] to [10].
[1] A laminate, including a support substrate and a polyimide resin layer on the support substrate, the support substrate including a step, wherein a polyimide resin constituting the polyimide resin layer has a structural unit of General Formula (1) set forth below, and a glass transition temperature of the polyimide resin is 300°C or higher: 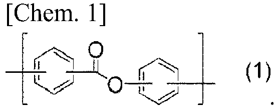
[2] The laminate according to [1], wherein, on the polyimide resin layer, an inorganic layer containing silicon is provided.
[3] The laminate according to [1] or [2], wherein a height of the step of the support substrate is from 0.1 to 50 µm.
[4] The laminate according to any one of [1] to [3], wherein a film thickness of the polyimide resin layer is from 0.5 to 300 µm.
[5] The laminate according to any one of [2] to [4], wherein the inorganic layer includes a silicon oxide or a silicon nitride.
[6] The laminate according to any one of [2] to [5], wherein a thickness of the inorganic layer is from 1 to 1,000 nm.
[7] The laminate according to any one of [1] to [6], wherein the support substrate includes silicon, silicon carbide, gallium nitride, gallium oxide, aluminum nitride, or diamond.
[8] A method for producing a laminate, the method including a step of obtaining a polyimide resin layer by applying a varnish of a polyimide resin or a varnish of a polyimide resin precursor onto a support substrate including a step and heating, wherein the polyimide resin or the polyimide resin precursor has a structural unit of General Formula (1) set forth below: 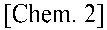 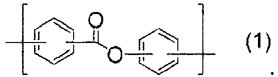
[9] The method for producing a laminate according to [8], further including a step of polishing a surface of the polyimide resin layer, the surface being opposite to a surface that is in contact with the support substrate.
[10] The method for producing a laminate according to [8] or [9], further including a step of laminating, on the laminate, an inorganic layer.

### Advantageous Effects of Invention

According to the present invention, it is possible to provide a laminate excellent in thermal resistance, adhesion, step embedding properties, and flatness. The laminate of the present invention has the properties as described above and is therefore useful as a laminate in the semiconductor process.

### Description of Embodiments

### [Laminate]

A laminate of the present invention is a laminate including a support substrate and a polyimide resin layer on the support substrate, the support substrate including a step, wherein a polyimide resin constituting the polyimide resin layer has a structural unit of General Formula (1) set forth below, and a glass transition temperature of the polyimide resin is 300°C or higher:

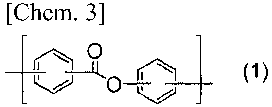

### <Support substrate including step>

The laminate of the present invention includes a support substrate that includes a step.

The support substrate is preferably silicon, silicon carbide, gallium nitride, gallium oxide, aluminum nitride, or diamond, and more preferably silicon.

When the support substrate is made of silicon, excellent film-deposition properties and thermal resistance are obtained. Further, silicon is excellent as the support substrate in the present invention because it is also excellent in yield in a crystal formation process and availability of raw materials.

The height of the step of the support substrate is preferably from 0.1 to 50 µm, more preferably from 1 to 40 µm, still more preferably from 1 to 20 µm, even more preferably from 1 to 15 µm, even more preferably from 1 to 10 µm.

The step of the support substrate is generated when the laminate of the present invention is a laminate for 2.x-dimensional or three-dimensional mounting. That is, the lower stage of the support substrate is a substrate (surface portion) on which a chip is disposed immediately above the support substrate, and the upper stage of the support substrate (portion narrower than the lower stage of the support substrate) is the upper surface of the chip disposed on the substrate. The substrate may be a substrate on which a silicon oxide layer, a silicon nitride layer, and an interlayer insulating layer (low-k film) are formed, or when the substrate is a silicon substrate, the substrate may be a silicon substrate on which an interlayer insulating layer (low-k film) is formed.

The polyimide resin layer described later functions as a planarization film for filling the step and planarizing the surface. It also functions as an insulating film.

### <Polyimide resin layer and polyimide resin>

The laminate of the present invention includes a polyimide resin layer on the support substrate.

The polyimide resin constituting the polyimide resin layer has a structural unit of General Formula (1) set forth below and has a glass transition temperature of 300°C or higher:

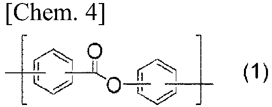

The film thickness of the polyimide resin layer is preferably from 0.5 to 300 µm, more preferably from 1 to 100 µm, still more preferably from 1 to 50 µm, even more preferably from 1 to 30 µm, even more preferably from 1 to 25 µm.

In particular, to fill the step of the support substrate, the film thicknesses of the polyimide resin layers are preferably different between a support substrate upper stage portion and a support substrate lower stage portion, and the difference in film thickness between the polyimide resin layers of the support substrate upper stage portion and the support substrate lower stage portion is preferably from 0.1 to 50 µm, more preferably from 1 to 40 µm, still more preferably from 1 to 20 µm, even more preferably from 1 to 15 µm, even more preferably from 1 to 10 µm.

In the present invention, the "film thickness of the polyimide resin layer" refers to the film thickness of the polyimide resin layer on the support substrate upper stage portion of the support substrate including a step (film thickness of the polyimide resin layer on the support substrate upper stage portion). That is, the "film thickness of the polyimide resin layer" refers to the film thickness of the thinner one of the polyimide resin layers on the support substrate including a step. The film thickness of the polyimide resin layer on the support substrate lower stage portion of the support substrate including a step is referred to as "film thickness of the polyimide resin layer on the support substrate lower stage portion". That is, the "film thickness of the polyimide resin layer on the support substrate lower stage portion" refers to the film thickness of the thicker one of the polyimide resin layers on the support substrate including a step.

The film thickness of the polyimide resin layer on the support substrate lower stage portion is preferably from 0.5 to 350 µm, more preferably from 1 to 150 µm, still more preferably from 1 to 100 µm, even more preferably from 1 to 50 µm.

The polyimide resin has a structural unit of General Formula (1) set forth below and has a glass transition temperature of 300°C or higher:

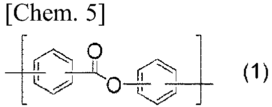

The glass transition temperature of the polyimide resin is 300°C or higher. The glass transition temperature of the polyimide resin is preferably 350°C or higher, more preferably 380°C or higher, still more preferably 400°C or higher, even more preferably 420°C or higher, even more preferably 430°C or higher, even more preferably 440°C or higher. The upper limit is not limited, but is preferably 550°C or lower. When the glass transition temperature of the polyimide resin is within the range, the laminate of the present invention is excellent in thermal resistance, and is useful as a laminate in the semiconductor process.

The reason for the laminate of the present invention having excellent thermal resistance, adhesion, step embedding properties, and flatness is not clear, but is considered as follows.

It is considered that because the polyimide resin precursor of the present invention applied to the support substrate including a step has a structure derived from a specific diamine having an ester skeleton having high linearity and exhibiting relatively low water absorbability, the resin obtained after thermal imidization has excellent thermal resistance. In addition, it is considered that because the polyimide resin precursor of the present invention has the structure described above, the resulting resin hardly absorbs moisture that inhibits adhesion. Thus, it is considered that the resin is excellent in adhesion and embedding properties, and has strong adhesion with which the resin does not peel off from the support substrate even in a planarization step such as polishing.

The polyimide resin has a structural unit of Formula (1), preferably has at least one structural unit selected from the group consisting of a structural unit of Formula (1a) set forth below and a structural unit of Formula (1b) set forth below, still more preferably has a structural unit of Formula (1b) set forth below:

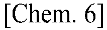

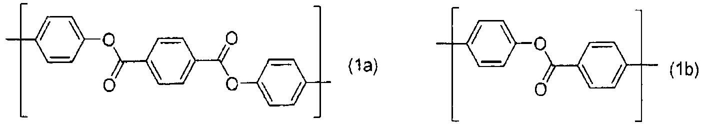

The polyimide resin having the structural unit of Formula (1a) more preferably includes at least one selected from the group consisting of a repeating unit represented by Formula (2a) set forth below and a repeating unit represented by Formula (3a) set forth below, still more preferably includes a repeating unit represented by Formula (2a) set forth below, even more preferably includes a repeating unit represented by Formula (2a) set forth below and a repeating unit represented by Formula (3a) set forth below:

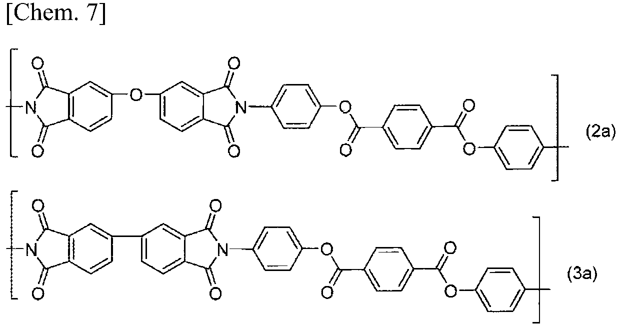

The "repeating unit" in the polyimide resin is an imide unit including a structural unit derived from one tetracarboxylic dianhydride and a structural unit derived from one diamine.

The proportion of the repeating unit represented by Formula (2a) to the total of the repeating unit represented by Formula (2a) and the repeating unit represented by Formula (3a) is preferably from 30 to 100 mol%, and from the viewpoint of transparency, it is more preferably from 40 to 100 mol%, still more preferably from 50 to 100 mol%, even more preferably from 60 to 100 mol%, even more preferably from 70 to 100 mol%, even more preferably from 80 to 100 mol%, even more preferably 90 to 100 mol%, and it may be 100 mol%. The proportion is more preferably from 30 to 90 mol%, still more preferably from 30 to 80 mol%, even more preferably from 30 to 70 mol%, even more preferably from 30 to 60 mol%, even more preferably from 30 to 50 mol%, from the viewpoints of thermal resistance and strength.

From the viewpoints of thermal resistance and mechanical strength, the total of the repeating unit represented by Formula (2a) and the repeating unit represented by Formula (3a) is preferably 50 mol% or more and 100 mol% or less, more preferably 70 mol% or more and 100 mol% or less, with respect to all the repeating units of the polyimide resin. It is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and mechanical strength.

The repeating unit represented by Formula (2a) is preferably 40 mol% or more, more preferably 50 mol% or more, still more preferably 60 mol% or more, even more preferably 70 mol% or more, even more preferably 80 mol% or more, even more preferably 90 mol% or more, with respect to all the repeating units of the polyimide resin from the viewpoint of transparency. The upper limit is 100 mol% or less.

The polyimide resin may include a repeating unit other than the repeating unit represented by Formula (2a) and the repeating unit represented by General Formula (3a).

The content of the repeating unit other than the repeating unit represented by Formula (2a) or the repeating unit represented by General Formula (3a) is preferably 50 mol% or lower, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin, and it is more preferable that no repeating unit other than the repeating unit represented by Formula (2a) or the repeating unit represented by General Formula (3a) is included.

The polyimide resin having the structural unit of Formula (1b) more preferably includes a repeating unit represented by Formula (2b) set forth below:

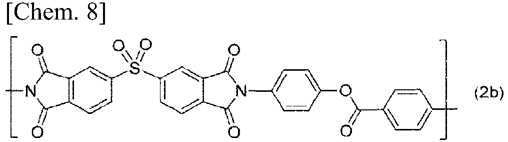

From the viewpoints of thermal resistance and mechanical strength, the repeating unit represented by Formula (2b) is preferably 50 mol% or more and 100 mol% or less, more preferably 70 mol% or more and 100 mol% or less, with respect to all the repeating units of the polyimide resin. The repeating unit is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. The repeating unit is even more preferably 100 mol% from the viewpoints of thermal resistance and adhesion.

The polyimide resin may include a repeating unit other than the repeating unit represented by Formula (2b).

The content of the repeating unit other than the repeating unit represented by Formula (2b) is preferably 50 mol% or less, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin, and it is more preferable that no repeating unit other than the repeating unit represented by Formula (2b) is included.

As described above, the polyimide resin even more preferably includes at least one selected from the group consisting of a repeating unit represented by Formula (2a), a repeating unit represented by Formula (3a), and a repeating unit represented by Formula (2b), even more preferably includes a repeating unit represented by Formula (2b). The inclusion of the repeating unit represented by Formula (2b) is preferable because the polyimide resin can be dissolved in any solvents, particularly in ester solvents, when varnishes are prepared.

### <Structural units of polyimide resin>

The polyimide resin has a structural unit A derived from a tetracarboxylic dianhydride and a structural unit B derived from a diamine.

In the polyimide resin, the structural unit A and the structural unit B form an imide structure.

The structural unit A preferably includes at least one selected from the group consisting of a structural unit (A1) derived from a compound represented by Formula (a1) described below, a structural unit (A2) derived from a compound represented by Formula (a2) described below, and a structural unit (A3) derived from a compound represented by Formula (a3) described below. The structural unit B preferably includes at least one selected from the group consisting of a structural unit (B1) derived from a compound represented by Formula (b1) described below, a structural unit (B2) derived from a compound represented by Formula (b2) described below, and a structural unit (B3) derived from a compound represented by Formula (b3) described below:

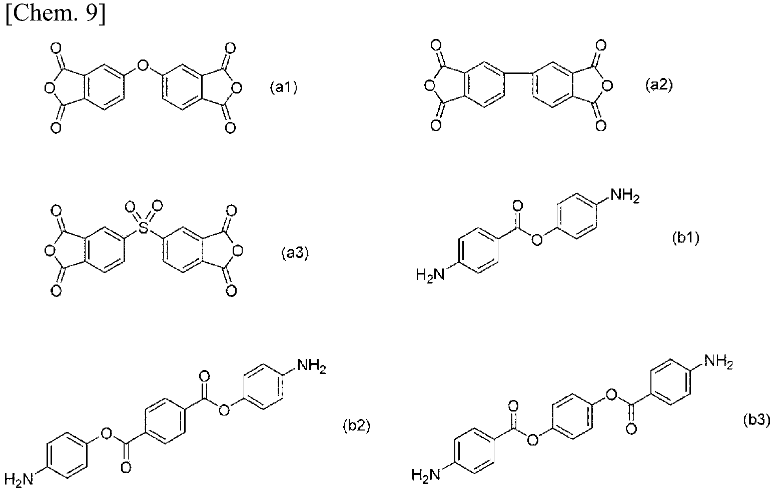

### (Structural unit A)

The structural unit A is a structural unit derived from a tetracarboxylic dianhydride, preferably includes at least one selected from the group consisting of a structural unit (A1) derived from a compound represented by Formula (a1), a structural unit (A2) derived from a compound represented by Formula (a2), and a structural unit (A3) derived from a compound represented by Formula (a3), more preferably includes a structural unit (A3) derived from a compound represented by Formula (a3). When the structural unit A includes the structural unit (A1) derived from the compound represented by Formula (a1), the structural unit A more preferably includes the structural unit (A1) derived from the compound represented by Formula (a1) and the structural unit (A2) derived from the compound represented by Formula (a2).

The compound represented by Formula (a1) is 4,4'-oxydiphthalic anhydride (ODPA). By using the structural unit (A1) derived from the compound represented by Formula (a1) as a structural unit of the polyimide resin, excellent thermal resistance and strength is obtained in the polyimide resin.

The compound represented by Formula (a2) is 3,3',4,4'-biphenyltetracarboxylic dianhydride (s-BPDA). By using the structural unit (A2) derived from the compound represented by Formula (a2) as a structural unit of the polyimide resin, thermal resistance and strength can be further enhanced.

The compound represented by Formula (a3) is 3,3',4,4'-diphenylsulfonetetracarboxylic dianhydride (DSDA). By using the structural unit (A3) derived from the compound represented by Formula (a3) as a structural unit of the polyimide resin, thermal resistance and adhesion can be further enhanced.

The total of the proportion of the structural unit (A1), the proportion of the structural unit (A2), and the proportion of the structural unit (A3) in the structural unit A is preferably 50 mol% or more and 100 mol% or less. The total is more preferably 70 mol% or more and 100 mol% or less, still more preferably 80 mol% or more and 100 mol% or less, still more preferably 90 mol% or more and 100 mol% or less, even more preferably 95 mol% or more and 100 mol% or less, even more preferably 99 mol% or more and 100 mol% or less, and it may be 100 mol%. The total is even more preferably 100 mol% from the viewpoints of thermal resistance and mechanical strength.

When the structural unit A includes the structural unit (A1) and the structural unit (A2), the proportion of the total of the structural unit (A1) and the structural unit (A2) in the structural unit A is preferably 50 mol% or more and 100 mol% or less, more preferably 70 mol% or more and 100 mol% or less. It is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and mechanical strength.

The proportion of the structural unit (A1) to the total of the structural unit (A1) and the structural unit (A2) is preferably from 30 to 100 mol%, and from the viewpoints of thermal resistance and strength, it is more preferably from 40 to 100 mol%, still more preferably from 50 to 100 mol%, even more preferably from 60 to 100 mol%, even more preferably from 70 to 100 mol%, even more preferably from 80 to 100 mol%, even more preferably 90 to 100 mol%, and it may be 100 mol%. The proportion is more preferably from 30 to 90 mol%, still more preferably from 30 to 80 mol%, even more preferably from 30 to 70 mol%, even more preferably from 30 to 60 mol%, even more preferably from 30 to 50 mol%, from the viewpoints of thermal resistance and strength.

The proportion of the structural unit (A1) in the structural unit A is preferably 40 mol% or more, more preferably 50 mol% or more, still more preferably 60 mol% or more, even more preferably 70 mol% or more, even more preferably 80 mol% or more, even more preferably 90 mol% or more, from the viewpoints of thermal resistance and strength. The upper limit is 100 mol% or less.

When the structural unit A includes the structural unit (A3), the proportion of the structural unit (A3) in the structural unit A is preferably 50 mol% or more and 100 mol% or less. The proportion is more preferably 70 mol% or more and 100 mol% or less, still more preferably 80 mol% or more and 100 mol% or less, still more preferably 90 mol% or more and 100 mol% or less, even more preferably 95 mol% or more and 100 mol% or less, even more preferably 99 mol% or more and 100 mol% or less, and it may be 100 mol%. The proportion is even more preferably 100 mol% from the viewpoints of thermal resistance and adhesion.

The structural unit A may include a structural unit other than the structural unit (A1), the structural unit (A2), and the structural unit (A3). Such a structural unit is not particularly limited, and examples thereof include a structural unit derived from an aromatic tetracarboxylic dianhydride, a structural unit derived from an alicyclic tetracarboxylic dianhydride, and a structural unit derived from an aliphatic tetracarboxylic dianhydride, other than the structural unit (A1), the structural unit (A2), and the structural unit (A3).

Examples of the aromatic tetracarboxylic dianhydride that provides a structural unit derived from the aromatic tetracarboxylic dianhydride other than the structural unit (A1), the structural unit (A2), and the structural unit (A3) include pyromellitic dianhydride (PMDA), 3,3',4,4'-benzophenone tetracarboxylic dianhydride (BTDA), 9,9-bis(trifluoromethyl)-9H-xanthene-2,3,6,7-tetracarboxylic dianhydride (6FCDA), 2,2-bis[4-(3,4-dicarboxyphenoxy)phenyl]hexafluoropropane dianhydride, 2,3,3',4'-biphenyltetracarboxylic dianhydride (a-BPDA), 9,9'-bis(3,4-dicarboxyphenyl)fluorene dianhydride (BPAF), hydroquinone diphthalic anhydride (HQDEA), ethylene glycol bis(trimellitate)dianhydride (TMEG), p-phenylene bis(trimellitate)dianhydride (TAHQ), 4,4'-(hexafluoroisopropylidene)diphthalic anhydride (6FDA), 2,2',3,3',5,5'-hexamethyl[1,1'-biphenyl]-4,4'-diyl=bis(1,3-dioxo-1,3-dihydro-2-benzofuran-5-carboxylate) (TMPBP-TME), 2,2-bis(3,4-dicarboxyphenyl)-propane dianhydride, spiro[11H-difuro[3,4-b:3',4'-i]xanthene-11,9'-[9H]fluorene]-1,3,7,9-tetrone (SFDA), 4,4'-thiodiphthalic anhydride, 5-[4-(1,3-dioxo-2-benzofuran-5-yl)phenyl]-2-benzofuran-1,3-dione, 5-[3-(1,3-dioxo-2-benzofuran-5-yl)phenyl]-2-benzofuran-1,3-dione, and p-biphenylene bis(trimellitic acid monoester acid anhydride) (BP-TME).

Among these, pyromellitic dianhydride (PMDA) is preferable. When the structural unit A has a structural unit derived from PMDA, a laminate having adhesion, step embedding properties, flatness, and thermal resistance is obtained.

Examples of the alicyclic tetracarboxylic dianhydride that provides a structural unit derived from the alicyclic tetracarboxylic dianhydride include cyclohexane-1,2,4,5-tetracarboxylic dianhydride (HPMDA), cyclohexane-1,2,3,4-tetracarboxylic dianhydride, 1,2,3,4-cyclobutanetetracarboxylic dianhydride, 1,2,3,4-cyclopentanetetracarboxylic dianhydride, 1,2,4,5-cyclopentanetetracarboxylic dianhydride, 3,3',4,4'-bicyclohexyltetracarboxylic dianhydride, 1,2,3,4-tetramethyl-1,2,3,4-cyclobutanetetracarboxylic dianhydride, decahydro-1,4:5,8-dimethanonaphthalene-2,3,6,7-tetracarboxylic dianhydride (DNDA), 5,5'-(1,4-phenylene)-bis[hexahydro-4,7-Methanoisobenzofuran-1,3-dione], 5,5'-bis-2-norbornene-5,5',6,6'-tetracarboxylic acid-5,5',6,6'-dianhydride, norbornane-2-spiro-α-cyclopentanone-u'-spiro-2''-norbornane-5,5',6,6'-tetracarboxylic acid dianhydride (CpODA), 2,2-propylidene-4,4'-bis(cyclohexane-1,2-dicarboxylic acid)dianhydride, oxy-4,4'-bis(cyclohexane-1,2-dicarboxylic acid)dianhydride, bicyclo[2.2.2]oct-7-ene-2,3,5,6-tetracarboxylic dianhydride, bicyclo[2.2.2]octane-2,3:5,6-tetracarboxylic dianhydride (BODA), and bicyclo[4.4.0]decane-2,3,6,7-tetracarboxylic dianhydride.

Examples of the aliphatic tetracarboxylic dianhydride that provides a structural unit derived from an aliphatic tetracarboxylic dianhydride include 1,2,3,4-butanetetracarboxylic dianhydride.

The structural unit optionally included in the structural unit A may be of one type or two or more types.

In the present specification, the term "aromatic tetracarboxylic dianhydride" refers to a tetracarboxylic dianhydride including one or more aromatic rings, the term "alicyclic tetracarboxylic dianhydride" refers to a tetracarboxylic dianhydride including one or more alicyclic rings and including no aromatic ring, and "aliphatic tetracarboxylic dianhydride" refers to a tetracarboxylic dianhydride including no aromatic ring and no alicyclic ring.

### (Structural unit B)

The structural unit B is a structural unit derived from a diamine, and it preferably includes at least one selected from the group consisting of a structural unit (B1) derived from a compound represented by Formula (b1), a structural unit (B2) derived from a compound represented by Formula (b2), and a structural unit (B3) derived from a compound represented by Formula (b3), more preferably includes at least one selected from the group consisting of a structural unit (B1) derived from a compound represented by Formula (b1) and a structural unit (B2) derived from a compound represented by Formula (b2), still more preferably includes a structural unit (B1) derived from a compound represented by Formula (b1).

The compound represented by Formula (b1) is 4-aminophenyl-4-aminobenzoate (4-BAAB). When the structural unit B includes the structural unit (B1), the thermal resistance of the resulting polyimide resin is excellent, and the adhesion can also be improved.

The compound represented by Formula (b2) is bis(4-aminophenyl)terephthalate (APTP). When the structural unit B includes the structural unit (B2), the thermal resistance of the resulting polyimide resin is excellent, and the adhesion of the polyimide resin can also be improved.

The compound represented by Formula (b3) is 1,4-bis(4-aminobenzoyloxy)benzene. When the structural unit B includes the structural unit (B3), the thermal resistance of the resulting polyimide resin is excellent, and the adhesion of the polyimide resin can also be improved.

The total of the proportion of the structural unit (B1), the proportion of the structural unit (B2), and the proportion of the structural unit (B3) in the structural unit B is preferably from 30 to 100 mol%, more preferably from 70 to 100 mol%, still more preferably from 90 to 100 mol%, even more preferably from 95 to 100 mol%, and it may be 100 mol%, and the structural unit B may include only at least one selected from the group consisting of the structural unit (B1), the structural unit (B2), and the structural unit (B3).

The proportion of the structural unit (B1) in the structural unit B is preferably from 30 to 100 mol%, more preferably from 70 to 100 mol%, still more preferably from 90 to 100 mol%, even more preferably from 95 to 100 mol%, and it may be 100 mol%. The structural unit B may include only the structural unit (B1).

The proportion of the structural unit (B2) in the structural unit B is preferably from 30 to 100 mol%, more preferably from 70 to 100 mol%, still more preferably from 90 to 100 mol%, even more preferably from 95 to 100 mol%, and it may be 100 mol%. The structural unit B may include only the structural unit (B2).

The proportion of the structural unit (B3) in the structural unit B is preferably from 30 to 100 mol%, more preferably from 70 to 100 mol%, still more preferably from 90 to 100 mol%, even more preferably from 95 to 100 mol%, and it may be 100 mol%. The structural unit B may include only the structural unit (B3).

When the proportions of the structural unit (B1), the structural unit (B2), and the structural unit (B3) are within the above ranges, the thermal resistance of the resulting polyimide resin is excellent, and the application properties of the varnish and the adhesion of the polyimide resin can also be improved.

The structural unit B may include a structural unit other than the structural unit (B1), the structural unit (B2), or the structural unit (B3). The diamine that provides such a structural unit is not particularly limited, and examples thereof include aromatic diamines, alicyclic diamines, and aliphatic diamines excluding any of the compound represented by Formula (b1), the compound represented by Formula (b2), and the compound represented by Formula (b3).

Examples of the aromatic diamine include 2,2'-bis(trifluoromethyl)-4,4'-diaminodiphenyl ether (6FODA), 2,2'-bis(trifluoromethyl)-4,4'-diaminobiphenyl (2,2'-TFMB), 3,3'-bis(trifluoromethyl)-4,4'-diaminobiphenyl, 2,2'-bis(trifluoromethyl)-5,5'-diaminobiphenyl, 2,2-bis(4-aminophenyl)hexafluoropropane (HFDA), 2,2-bis(3-amino-4-methylphenyl)hexafluoropropane, 2,2-bis[4-(4-aminophenoxy)phenyl]hexafluoropropane (HFBAPP), 4,4'-diaminodiphenyl ether (4,4'-ODA), 3,4'-diaminodiphenyl ether, 4,4'-diaminodiphenyl methane (DDM), 4,4'-diaminodiphenyl sulfone (4,4'-DDS), 3,3'-diaminodiphenyl sulfone (3,3'-DDS), 4,4'-diamino-2,2'-dimethylbiphenyl (mTB), 9,9-bis(4-aminophenyl)fluorene (BAFL), 4,4'-diaminobiphenyl (benzidine), 4,4'-diamino-3,3'-dimethylbiphenyl, 4,4'-diaminodiphenyl sulfide, 4,4'-diaminobenzophenone, 2,2-bis(3-aminophenyl)propane, 2,2-bis(4-aminophenyl)propane, 5-amino-1,3,3-trimethyl-1-(4-aminophenyl)-indane (5-TMDM), 6-amino-1,3,3-trimethyl-1-(4-aminophenyl)-indane (6-TMDM), 1,3-bis(3-amino-α,α-dimethylbenzyl)benzene, 1,3-bis(4-amino-α,α-dimethylbenzyl)benzene (BisAM), 1,4-bis(4-amino-α,α-dimethylbenzyl)benzene (BisAP), 4,4'-bis(3-aminophenoxy)biphenyl, 4,4'-bis(4-aminophenoxy)biphenyl (BODA), 1,1-bis[4-(4-aminophenoxy)phenyl]cyclohexane, 2,2-bis[4-(4-aminophenoxy)phenyl]propane (BAPP), 1,4-bis(3-aminophenoxy)benzene, 1,4-bis(4-aminophenoxy)benzene, 1,3-bis(3-aminophenoxy)benzene, 1,3-bis(4-aminophenoxy)benzene, bis[4-(3-aminophenoxy)phenyl]ketone, bis[4-(4-aminophenoxy)phenyl]ketone, bis[4-(3-aminophenoxy)phenyl]sulfide, bis[4-(4-aminophenoxy)phenyl]sulfide, bis[4-(3-aminophenoxy)phenyl]ether, bis[4-(4-aminophenoxy)phenyl]ether, bis[4-(3-aminophenoxy)phenyl]sulfone, bis[4-(4-aminophenoxy)phenyl]sulfone, 4,4-diaminobenzanilide, 4-aminobenzoic acid-4-aminophenyl, and 3,4-diaminobenzanilide.

Examples of the alicyclic diamine include 1,3-bis(aminomethyl)cyclohexane (1,3-BAC), 1,4-bis(aminomethyl)cyclohexane, 1,3-cyclohexyldiamine, 1,4-cyclohexyldiamine, isophorone diamine, bis(aminomethyl)norbornane, 4,4'-diaminodicyclohexylmethane, 4,4'-diaminodicyclohexyl ether, and 2,2-bis(4-aminocyclohexyl)propane.

Examples of the aliphatic diamine include ethylenediamine and hexamethylenediamine.

In the present specification, the term "aromatic diamine" refers to a diamine including one or more aromatic rings, the term "alicyclic diamine" refers to a diamine including one or more alicyclic rings and including no aromatic ring, and the term "aliphatic diamine" refers to a diamine including no aromatic ring and no alicyclic ring.

The structural unit optionally included in the structural unit B, other than the structural unit (B1), the structural unit (B2), or the structural unit (B3) may be of one type or two or more types.

The polyimide resin may have a structure other than a polyimide chain (structure in which the structural unit A and the structural unit B are imide-bonded) as long as the present invention is not impaired. As the structure, other than the polyimide chain, that can be contained in the polyimide resin, examples thereof include a structure containing an amide bond.

The polyimide resin preferably contains a polyimide chain (structure in which the structural unit A and the structural unit B are imide-bonded) as a main structure. Thus, the proportion of the polyimide chain in the polyimide resin is preferably 80 mass% or more, more preferably 90 mass% or more, still more preferably 99 mass% or more, even more preferably 100 mass%.

### <Method for producing polyimide resin>

The polyimide resin may be produced by any methods, but is preferably produced by the following methods.

The polyimide resin may be obtained directly by polymerizing a diamine (hereinafter, also referred to as a diamine component) and a tetracarboxylic dianhydride (hereinafter, also referred to as a tetracarboxylic acid component), or may be obtained by polymerizing a diamine and a tetracarboxylic dianhydride to obtain a polyamic acid or an imide-amic acid copolymer, which is a precursor of the polyimide resin (polyimide resin precursor), and imidizing the polyamic acid or the imide-amic acid copolymer at the time of producing a laminate. A method of obtaining a polyimide resin precursor and imidizing the polyimide resin precursor when a laminate is produced is preferable.

Here, an imide-amic acid copolymer as a polyimide resin precursor, a method for producing a polyamic acid, and a method for producing a polyimide resin for directly obtaining a polyimide resin will be described. The polyimide resin precursor and the polyimide resin may be collectively referred to as a polymer.

### (Method for producing imide-amic acid copolymer as polyimide resin precursor)

A preferable production method in the case of a polymer containing both an imide unit and an amic acid unit (hereinafter, also referred to as an imide-amic acid copolymer) includes the following Step 1 and the following Step 2.

Step 1: a step of causing a tetracarboxylic dianhydride and a diamine to react in the presence of a solvent to obtain an imide oligomer.

Step 2: a step of mixing and polymerizing the imide oligomer obtained in Step 1 and at least either a tetracarboxylic dianhydride or a diamine.

### [Step 1]

Step 1 is a step of causing a tetracarboxylic dianhydride and a diamine that constitute an imide moiety to react in the presence of a solvent to obtain an imide oligomer.

In Step 1, the amount of the diamine with respect to the tetracarboxylic dianhydride is preferably from 1.01 to 2 mol, more preferably from 1.05 to 1.9 mol, still more preferably from 1.1 to 1.7 mol.

The method for causing a tetracarboxylic dianhydride and a diamine to react to obtain an imide oligomer in Step 1 is not particularly limited, and a known method can be used.

Specific examples of the reaction method include (1) a method in which a tetracarboxylic dianhydride, a diamine, and a solvent are fed into a reactor, this mixture is stirred at a temperature from 10 to 110°C for a period of time ranging from 0.5 to 30 hours, followed by increasing the temperature to perform an imidization reaction, (2) a method in which a diamine and a solvent are fed into a reactor and dissolved, then a tetracarboxylic dianhydride is added thereto, this mixture is stirred at room temperature of from 10 to 110°C for a period of time ranging from 0.5 to 30 hours as necessary, followed by increasing the temperature to perform an imidization reaction, and (3) a method in which a tetracarboxylic dianhydride, a diamine, and a solvent are fed into a reactor, and then immediately increasing the temperature to perform an imidization reaction.

In the imidization reaction, the reaction is preferably performed with a Dean-Stark apparatus or the like to remove water produced during the production. By performing such operation, the degree of polymerization and the degree of imidization can be further increased.

In the imidization reaction described above, a known imidization catalyst can be used. As the imidization catalyst, a base catalyst or an acid catalyst can be exemplified.

Examples of the base catalyst include: organic base catalysts such as pyridine, quinoline, isoquinoline, α-picoline, β-picoline, 2,4-lutidine, 2,6-lutidine, trimethylamine, triethylamine, tripropylamine, tributylamine, triethylenediamine, imidazole, N,N-dimethylaniline, and N,N-diethylaniline; and inorganic base catalysts such as potassium hydroxide, sodium hydroxide, potassium carbonate, sodium carbonate, potassium hydrogen carbonate, and sodium hydrogen carbonate.

Examples of the acid catalyst include crotonic acid, acrylic acid, trans-3-hexenoic acid, cinnamic acid, benzoic acid, methylbenzoic acid, oxybenzoic acid, terephthalic acid, benzenesulfonic acid, p-toluenesulfonic acid, and naphthalenesulfonic acid. The imidization catalysts described above may be used alone, or two or more types thereof may be used in combination.

Among the catalysts described above, from the viewpoint of handleability, a base catalyst is preferable, an organic base catalyst is more preferable, one or more selected from the group consisting of triethylamine and triethylenediamine is still more preferable, and triethylamine is even more preferable.

The temperature for the imidization reaction is preferably in a range from 120 to 250°C, and more preferably from 160 to 200°C, from the viewpoints of reaction rate and suppression of gelling or the like. The reaction time is preferably from 0.5 to 10 hours after the start of distillation of produced water.

Through the method described above, a solution containing the imide oligomer dissolved in the solvent is obtained. The solution containing the imide oligomer obtained in Step 1 may contain at least a part of the components used as the tetracarboxylic dianhydride or the diamine in Step 1 as an unreacted monomer as long as the effect of the present invention is not impaired.

### [Step 2]

Step 2 is a step of mixing and polymerizing the imide oligomer obtained in Step 1 and at least either a tetracarboxylic dianhydride or a diamine.

The amount of the diamine component with respect to the tetracarboxylic acid component in all of Step 1 and Step 2 is preferably from 0.9 to 1.1 mol.

In Step 2, the method for polymerizing the imide oligomer obtained in Step 1, a tetracarboxylic dianhydride, and a diamine is not particularly limited, and a known method can be used.

Specific examples of the reaction method include (1) a method in which an imide oligomer and at least either a tetracarboxylic dianhydride or a diamine are fed into a reactor and stirred at a temperature in the range of from 0 to 120°C, preferably from 5 to 80°C for a period of time ranging from 1 to 72 hours, and (2) a method in which the imide oligomer and a solvent are fed into a reactor and dissolved, and then at least either a tetracarboxylic dianhydride or a diamine is fed and stirred at a temperature in the range of from 0 to 120°C, preferably from 5 to 80°C for a period of time ranging from 1 to 72 hours.

When the reaction is performed at 80°C or lower, the molecular weight of the copolymer obtained in Step 2 does not vary depending on the temperature history at the time of polymerization, and the progress of thermal imidization can also be suppressed. Thus, the copolymer can be stably produced.

The concentration of the copolymer in the resulting solution is preferably from 1 to 50 mass%, more preferably from 3 to 35 mass%, still more preferably from 5 to 30 mass%.

### (Method for producing polyamic acid as polyimide resin precursor)

A preferable method for producing a polyimide resin precursor when the polyimide resin precursor is a polyamic acid is a method in which a tetracarboxylic dianhydride and a diamine are caused to react in the presence of a solvent to obtain a polyamic acid.

The method for polymerizing a tetracarboxylic dianhydride and a diamine is not particularly limited, and a known method can be used.

Specific examples of the reaction method include a method in which a solution containing a diamine and a solvent and a tetracarboxylic dianhydride are fed into a reactor and stirred at a temperature in the range of from 0 to 120°C, preferably from 5 to 80°C for a period of time ranging from 1 to 72 hours.

The diamine component with respect to the tetracarboxylic acid component is preferably from 0.9 to 1.1 mol.

When performing the reaction at 80°C or lower, the molecular weight of the polyamic acid does not vary depending on the temperature history during polymerization, and the progress of thermal imidization can also be suppressed. Thus, the polyamic acid can be stably produced.

The concentration of the polyamic acid in the resulting solution is preferably from 1 to 50 mass%, more preferably from 3 to 35 mass%, still more preferably from 5 to 30 mass%.

### (Method for producing polyimide resin)

A preferable production method in the case of directly obtaining a polyimide resin is a method in which a tetracarboxylic dianhydride and a diamine are caused to react in the presence of a solvent to obtain a polyimide resin.

The method for polymerizing a tetracarboxylic dianhydride and a diamine is not particularly limited, and a known method can be used.

Specific examples of the reaction method include (1) a method in which a solution containing a diamine and a solvent and a tetracarboxylic dianhydride are fed into a reactor, stirred at from 10 to 110°C for a period of time ranging from 0.5 to 30 hours as necessary, and then heated to perform an imidization reaction, and (2) a method in which a solution containing a diamine and a solvent and a tetracarboxylic dianhydride are fed into a reactor, and immediately heated to perform an imidization reaction.

In the imidization reaction, the reaction is preferably performed with a Dean-Stark apparatus or the like to remove water produced during the production. By performing such operation, the degree of polymerization and the degree of imidization can be further increased.

In the imidization reaction described above, a known imidization catalyst can be used. As the imidization catalyst, a base catalyst or an acid catalyst can be exemplified.

Examples of the base catalyst include: organic base catalysts such as pyridine, quinoline, isoquinoline, α-picoline, β-picoline, 2,4-lutidine, 2,6-lutidine, trimethylamine, triethylamine, tripropylamine, tributylamine, triethylenediamine, imidazole, N,N-dimethylaniline, and N,N-diethylaniline; and inorganic base catalysts such as potassium hydroxide, sodium hydroxide, potassium carbonate, sodium carbonate, potassium hydrogen carbonate, and sodium hydrogen carbonate.

Examples of the acid catalyst include crotonic acid, acrylic acid, trans-3-hexenoic acid, cinnamic acid, benzoic acid, methylbenzoic acid, oxybenzoic acid, terephthalic acid, benzenesulfonic acid, p-toluenesulfonic acid, and naphthalenesulfonic acid. The imidization catalysts described above may be used alone, or two or more types thereof may be used in combination.

Among the catalysts described above, from the viewpoint of handleability, a base catalyst is preferable, an organic base catalyst is more preferable, one or more selected from the group consisting of triethylamine and triethylenediamine is still more preferable, and triethylamine is even more preferable.

The temperature for the imidization reaction is preferably in a range from 120 to 250°C, and more preferably from 160 to 200°C, from the viewpoints of reaction rate and suppression of gelling or the like. The reaction time is preferably from 0.5 to 10 hours after the start of distillation of produced water.

The concentration of the polyimide in the resulting solution is preferably from 1 to 50 mass%, more preferably from 3 to 35 mass%, still more preferably from 5 to 30 mass%.

Next, raw materials and the like used in the method for producing the imide-amic acid copolymer, the polyamic acid, and the polyimide resin will be described.

### [Tetracarboxylic dianhydride]

The tetracarboxylic dianhydride used as a raw material in the production method is preferably the tetracarboxylic dianhydride described in the structural unit A of the polyimide resin.

Examples of the tetracarboxylic dianhydride include, but are not limited to, acid dianhydrides, and a derivative thereof may also be used as long as it is within a range of providing the structural unit A. Examples of the derivative include a tetracarboxylic acid (free acid) and an alkyl ester of the tetracarboxylic acid. Among these, acid dianhydride is preferable.

### [Diamine]

The diamine used as a raw material in the production method is preferably the diamine described in the structural unit B of the polyimide resin.

Examples of the diamine include, but are not limited to, diamines, and a derivative thereof may also be used as long as it is within a range of providing the structural unit B in the polymer. Examples of the derivative include diisocyanates corresponding to the diamine. Among these, a diamine is preferable.

### [End-capping agent]

Other than the tetracarboxylic acid component or the diamine component described above, an end-capping agent may also be used in the production of the polymer. The end-capping agent is preferably used in Step 2 in the production of the imide-amic acid copolymer.

As the end-capping agent, acid anhydrides, monoamines, or dicarboxylic acids are preferable. The amount of the end-capping agent to be introduced is preferably from 0.0001 to 20 mol, more preferably from 0.1 to 10 mol, still more preferably from 0.5 to 5 mol, with respect to 1 mol of the tetracarboxylic acid component. Examples of the monoamine end-capping agent to be recommended include methylamine, ethylamine, propylamine, butylamine, benzylamine, 4-methylbenzylamine, 4-ethylbenzylamine, 4-dodecylbenzylamine, 3-methylbenzylamine, 3-ethylbenzylamine, aniline, 3-methylaniline, 4-methylaniline, o-aminophenol, m-aminophenol, p-aminophenol, o-aminobenzoic acid, m-aminobenzoic acid, and p-aminobenzoic acid. Among these, benzylamine, aniline, o-aminophenol, m-aminophenol, p-aminophenol, o-aminobenzoic acid, m-aminobenzoic acid, and p-aminobenzoic acid can be suitably used. As the dicarboxylic acid end-capping agent, dicarboxylic acids are preferable, and a part thereof may be ring-closed. Recommended examples thereof include phthalic acid, phthalic anhydride, 4-chlorophthalic acid, tetrafluorophthalic acid, 2,3-benzophenone dicarboxylic acid, 3,4-benzophenone dicarboxylic acid, cyclopentane-1,2-dicarboxylic acid, 4-cyclohexene-1,2-dicarboxylic acid, and trimellitic anhydride. Among these, phthalic acid, phthalic anhydride, and trimellitic anhydride can be suitably used.

### [Solvent]

The solvent to be used in the method for producing a polymer may be any solvent that can dissolve the polymer to be produced. Examples of the solvent include aprotic solvents, phenol-based solvents, ether-based solvents, and carbonate-based solvents.

Specific examples of the aprotic solvent include amide-based solvents such as cyclic amides and chain amides, phosphorus-containing amide-based solvents, sulfur-containing solvents, ketone-based solvents, and ester-based solvents containing cyclic esters.

Examples of the cyclic amide include N-methylpyrrolidone, N-methylcaprolactam, and 1,3-dimethylimidazolidinone. N-methylpyrrolidone is preferable.

Examples of the chain amide include N,N-dimethylformamide, N,N-dimethylacetamide, and tetramethylurea.

Examples of the cyclic ester include γ-butyrolactone and γ-valerolactone.

Examples of the ester-based solvent include acetic acid(2-methoxy-1-methylethyl).

Examples of the phosphorus-containing amide-based solvent include hexamethylphosphoric amide and hexamethylphosphine triamide.

Examples of the sulfur-containing solvent include dimethyl sulfone, dimethyl sulfoxide, and sulfolane.

Examples of the ketone-based solvent include acetone, methyl ethyl ketone, cyclohexanone, and methyl cyclohexanone.

Specific examples of the phenol-based solvent include phenol, o-cresol, m-cresol, p-cresol, 2,3-xylenol, 2,4-xylenol, 2,5-xylenol, 2,6-xylenol, 3,4-xylenol, and 3,5-xylenol.

Specific examples of the ether-based solvent include 1,2-dimethoxyethane, bis(2-methoxyethyl)ether, 1,2-bis(2-methoxyethoxy)ethane, bis[2-(2-methoxyethoxy)ethyl]ether, tetrahydrofuran, and 1,4-dioxane.

Specific examples of the carbonate-based solvent include diethyl carbonate, methylethyl carbonate, ethylene carbonate, and propylene carbonate.

Among the solvents, at least one selected from the group consisting of a cyclic amide, a chain amide, and a cyclic ester is preferably included, at least one selected from the group consisting of a cyclic amide and a cyclic ester is more preferably included, and a cyclic ester is even more preferably included. More specifically, the solvent contains at least one selected from the group consisting of N-methylpyrrolidone and γ-butyrolactone, and more preferably contains γ-butyrolactone. The solvents described above may be used alone, or two or more types may be used as a mixture.

### (Polyimide resin precursor)

In the method for producing a polyimide resin and the method for producing a laminate described later, the polyimide resin precursor to be used as a raw material of the polyimide resin preferably has a structural unit of General Formula (1) set forth below:

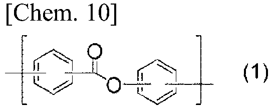

The polyimide resin precursor preferably has a structural unit of Formula (1), more preferably has at least one structural unit selected from the group consisting of a structural unit of Formula (1a) set forth below and a structural unit of Formula (1b) set forth below, still more preferably has a structural unit of Formula (1b) set forth below:

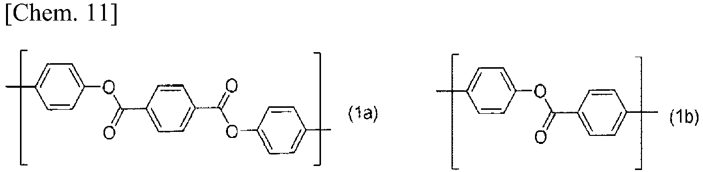

The polyimide resin precursor having the structural unit of Formula (1a) more preferably includes at least one selected from the group consisting of a repeating unit represented by Formula (4a) set forth below and a repeating unit represented by Formula (5a) set forth below, still more preferably includes a repeating unit represented by Formula (4a) set forth below, even more preferably includes a repeating unit represented by Formula (4a) set forth below and a repeating unit represented by Formula (5a) set forth below: 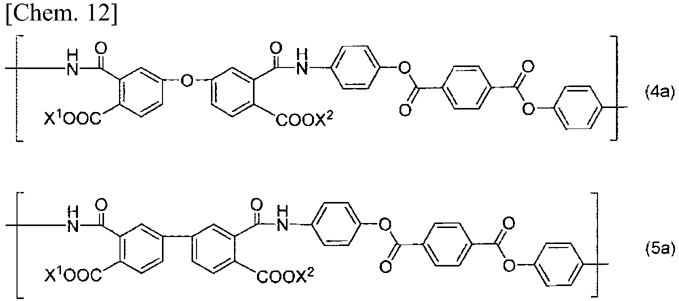 (In Formula (4a) and Formula (5a), X¹ and X² are each independently a hydrogen atom, an alkyl group having from 1 to 6 carbon atoms, or an alkylsilyl group having from 3 to 9 carbon atoms).

The "repeating unit" in the polyimide resin precursor is an amic acid unit including a structural unit derived from one tetracarboxylic dianhydride and a structural unit derived from one diamine.

In Formula (4a) and Formula (5a), X¹ and X² are each independently at least one selected from the group consisting of a hydrogen atom, an alkyl group having from 1 to 6 carbon atoms, and an alkylsilyl group having from 3 to 9 carbon atoms, preferably at least one selected from the group consisting of a hydrogen atom and an alkyl group having from 1 to 6 carbon atoms, more preferably a hydrogen atom.

The proportion of the repeating unit represented by Formula (4a) to the total of the repeating unit represented by Formula (4a) and the repeating unit represented by Formula (5a) is preferably from 30 to 100 mol%, and from the viewpoint of transparency, it is more preferably from 40 to 100 mol%, still more preferably from 50 to 100 mol%, even more preferably from 60 to 100 mol%, even more preferably from 70 to 100 mol%, even more preferably from 80 to 100 mol%, even more preferably 90 to 100 mol%, and it may be 100 mol%. The proportion is more preferably from 30 to 90 mol%, still more preferably from 30 to 80 mol%, even more preferably from 30 to 70 mol%, even more preferably from 30 to 60 mol%, even more preferably from 30 to 50 mol%, from the viewpoints of thermal resistance and strength.

From the viewpoints of thermal resistance and mechanical strength, the total of the repeating unit represented by Formula (4a) and the repeating unit represented by Formula (5a) is preferably 50 mol% or more and 100 mol% or less, more preferably 70 mol% or more and 100 mol% or less, with respect to all the repeating units of the polyimide resin precursor. It is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and mechanical strength.

The repeating unit represented by Formula (4a) is preferably 40 mol% or more, more preferably 50 mol% or more, still more preferably 60 mol% or more, even more preferably 70 mol% or more, even more preferably 80 mol% or more, even more preferably 90 mol% or more, with respect to all the repeating units of the polyimide resin precursor from the viewpoint of transparency. The upper limit is 100 mol% or less.

The polyimide resin precursor may include a repeating unit other than the repeating unit represented by Formula (4a) and the repeating unit represented by General Formula (5a).

The content of the repeating unit other than the repeating unit represented by Formula (4a) and the repeating unit represented by General Formula (5a) is preferably 50 mol% or less, more preferably 30 mol% or less, more preferably 20 mol% or less, still more preferably 10 mol% or less, even more preferably 5 mol% or less, even more preferably 1 mol% or less, even more preferably 0 mol%, with respect to all the repeating units of the polyimide resin precursor, and it is even more preferable that no repeating unit other than the repeating unit represented by Formula (4a) or the repeating unit represented by General Formula (5a) is included.

The polyimide resin precursor having the structural unit of Formula (1b) preferably includes a repeating unit represented by Formula (4b) set forth below: 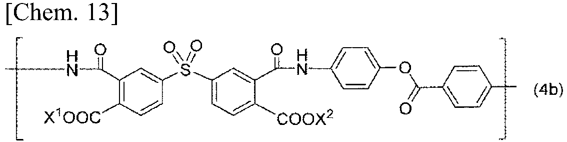 (In Formula (4b), X¹ and X² are each independently a hydrogen atom, an alkyl group having from 1 to 6 carbon atoms, or an alkylsilyl group having from 3 to 9 carbon atoms).

In Formula (4b), X¹ and X² are each independently at least one selected from the group consisting of a hydrogen atom, an alkyl group having from 1 to 6 carbon atoms, and an alkylsilyl group having from 3 to 9 carbon atoms, preferably at least one selected from the group consisting of a hydrogen atom and an alkyl group having from 1 to 6 carbon atoms, more preferably a hydrogen atom.

From the viewpoints of thermal resistance and mechanical strength, the repeating unit represented by Formula (4b) is preferably 50 mol% or more and 100 mol% or less, more preferably 70 mol% or more and 100 mol% or less, with respect to all the repeating units of the polyimide resin precursor. The repeating unit is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. The repeating unit is even more preferably 100 mol% from the viewpoints of thermal resistance and adhesion.

The polyimide resin precursor may include a repeating unit other than the repeating unit represented by Formula (4b).

The content of the repeating unit other than the repeating unit represented by Formula (4b) is preferably 50 mol% or less, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin precursor, and it is even more preferable that no repeating unit other than the repeating unit represented by Formula (4b) is included.

As described above, the polyimide resin precursor even more preferably includes at least one selected from the group consisting of a repeating unit represented by Formula (4a), a repeating unit represented by Formula (5a), and a repeating unit represented by Formula (4b), even more preferably includes a repeating unit represented by Formula (4b). The inclusion of the repeating unit represented by Formula (4b) is preferable because the polyimide resin can be dissolved in any solvents, particularly in ester-based solvents, when varnishes are prepared.

When the polyimide resin precursor is an imide-amic acid copolymer, the precursor preferably includes the repeating units described in this section and the repeating units described in the section of the polyimide resin. Specifically, as the imide moiety, the precursor preferably includes at least one selected from the group consisting of a repeating unit represented by Formula (2b), a repeating unit represented by Formula (2a), and a repeating unit represented by Formula (3a), more preferably includes at least one selected from the group consisting of a repeating unit represented by Formula (2b) and a repeating unit represented by the Formula (2a) set forth below, still more preferably includes a repeating unit represented by Formula (2b). Specifically, as the amic acid moiety, the precursor preferably includes at least one selected from the group consisting of a repeating unit represented by Formula (4b), a repeating unit represented by Formula (4a), and a repeating unit represented by Formula (5a), more preferably includes at least one selected from the group consisting of a repeating unit represented by Formula (4b) and a repeating unit represented by the Formula (4a) set forth below, still more preferably includes a repeating unit represented by Formula (4b).

### <Varnish>

The laminate of the present invention is preferably obtained by a method for producing a laminate, the method including a step of obtaining a polyimide resin layer by applying a varnish of a polyimide resin or a varnish of a polyimide resin precursor onto a support substrate including a step and heating. The polyimide resin or the polyimide resin precursor has a structural unit of General Formula (1).

Hereinafter, the varnishes used in the production of the laminate will be described, but preferable varnishes are the same for both the varnish containing the polyimide resin and the organic solvent constituting the polyimide resin layer and the varnish containing the precursor of the polyimide resin and the organic solvent constituting the polyimide resin layer. Thus, the varnishes will be collectively described as "varnish" below.

The varnish contains the polyimide resin and an organic solvent, or contains a polyimide resin precursor and an organic solvent.

The solvent is not particularly limited as long as it dissolves the polyimide resin or the polyimide resin precursor, but it is preferable to use the above-described compounds as the solvents used for producing the polyimide resin or the polyimide resin precursor alone or as a mixture of two or more types. Among the solvents described above, at least one selected from the group consisting of a cyclic amide, a chain amide, and a cyclic ester is preferably contained, a cyclic amide is more preferably contained, and N-methylpyrrolidone is still more preferably contained.

The varnish may be the polyimide resin solution or the polyimide resin precursor solution itself obtained by the above-described method for producing a polyimide resin or a polyimide resin precursor, may be obtained by further adding a solvent, or may be obtained by reducing the solvent through condensation or the like.

In the case of a varnish containing a polyimide resin precursor, the varnish can further contain an imidization catalyst and a dehydration catalyst from the viewpoint of efficiently progressing the imidization of the amic acid moiety. The imidization catalyst may have a boiling point of 40°C or higher and 180°C or lower, and is preferably an amine compound having a boiling point of 180°C or lower. The imidization catalyst with the boiling point of 180°C or lower is unlikely to cause coloration of the polyimide film during drying at a high temperature after the formation of the film, and thus such a catalyst does not impair the appearance of the laminate. In addition, in the case of an imidization catalyst having a boiling point of 40°C or higher, it is possible to avoid the possibility of volatilization of the imidization catalyst before sufficient imidization progresses.

Examples of the amine compound preferably used as the imidization catalyst include pyridines and picolines. The imidization catalysts described above may be used alone, or two or more types thereof may be used in combination.

Examples of the dehydration catalyst include: acid anhydrides such as acetic anhydride, propionic anhydride, n-butyric anhydride, benzoic anhydride, and trifluoroacetic anhydride; and carbodiimide compounds such as dicyclohexylcarbodiimide. These compounds may be used alone, or two or more types thereof may be used in combination.

Since the polyimide resin or the polyimide resin precursor contained in the varnish has solvent solubility, the varnish can have a high concentration. The varnish preferably contains the polyimide resin or the polyimide resin precursor in an amount of from 1 to 40 mass%, more preferably from 3 to 40 mass%, still more preferably from 5 to 30 mass%. The viscosity of the varnish is preferably from 0.1 to 200 Pa·s, more preferably from 1 to 20 Pa·s. The viscosity of the varnish is a value measured at 25°C using an E-type viscometer.

In addition, the varnish may contain various additives, such as inorganic fillers, adhesion promoters, release agents, flame retardants, ultraviolet stabilizers, surfactants, leveling agents, defoaming agents, fluorescent brightening agents, crosslinking agents, polymerization initiators, and photosensitizers, in the range that does not impair required characteristics of a polyimide film.

### <Inorganic layer>

The laminate of the present invention is a laminate including a support substrate including a step and a polyimide resin layer on the support substrate, the laminate preferably including an inorganic layer on the polyimide resin layer.

The inorganic layer preferably contains silicon. The inorganic layer more preferably includes at least one selected from the group consisting of silicon oxides and silicon nitrides. The inorganic layer is still more preferably composed of at least one selected from the group consisting of silicon oxides and silicon nitrides. The inorganic layer is even more preferably a silicon oxide or a silicon nitride, even more preferably a silicon nitride. When the inorganic layer is silicon nitride, the effect of the present invention can be sufficiently exhibited, and excellent layer-deposition properties and thermal resistance are obtained. Further, because silicon nitride is also excellent in barrier properties and chemical stability, the inorganic layer is excellent as an inorganic layer used for the laminate of the present invention.

The inorganic layer is an insulating layer. That is, the inorganic layer functions as an insulating layer and at the same time as a barrier layer in the laminate, and also functions as a buffer layer.

The thickness of the inorganic layer is preferably from 1 to 1,000 nm, more preferably from 1 to 400 nm, still more preferably from 10 to 300 nm, even more preferably from 20 to 200 nm.

### [Method for producing laminate]

The laminate of the present invention may be obtained by any production methods as long as it has the constitution described above, but it is preferably produced by the following method.

Specifically, the laminate is preferably produced by a method for producing a laminate, the method including a step of obtaining a polyimide resin layer by applying a varnish of a polyimide resin or a varnish of a polyimide resin precursor onto a support substrate including a step and heating, wherein the polyimide resin or the polyimide resin precursor has a structural unit of General Formula (1) set forth below:

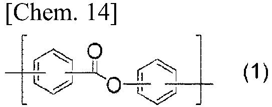

The support substrate including a step, the varnish of the polyimide resin, the varnish of the polyimide resin precursor, the polyimide resin, and the polyimide resin precursor in the present production method are as described above in the present specification, and preferable ranges are also as described above in the present specification.

### (Step of obtaining polyimide resin layer)

The present production method first includes a step of obtaining polyimide resin layer by applying a varnish of a polyimide resin or a varnish of a polyimide resin precursor onto a support substrate including a step and heating.

Through this step, a laminate in which the polyimide resin layer is laminated on the support substrate including a step is obtained.

The heating temperature is preferably 300°C or higher, more preferably from 300 to 500°C. The heating time is preferably from 1 minute to 6 hours, more preferably from 10 minutes to 3 hours, still more preferably from 20 minutes to 2 hours.

To remove the solvent contained in the varnish, preheating may be performed at from 60 to 250°C before heating to 300°C or higher. The preheating temperature is preferably from 60 to 250°C, more preferably from 70 to 180°C. The preheating time is preferably from 1 minute to 6 hours, more preferably from 5 minutes to 2 hours, still more preferably from 10 minutes to 1 hour. The preheating may be performed a plurality of times.

The heating atmosphere includes air, nitrogen gas, oxygen gas, hydrogen gas, nitrogen/hydrogen mixed gas, and the like, and to suppress the coloration of the resulting polyimide resin, nitrogen gas with an oxygen concentration of 100 ppm or less or nitrogen/hydrogen mixed gas containing hydrogen at a concentration of 0.5% or less is preferable.

### (Step of polishing)

The laminate of the present invention includes a polyimide resin layer on a support substrate including a step, but a surface of the polyimide resin layer of the laminate obtained in the step may be polished to improve the flatness of a surface of the laminate and improve the accuracy of bonding of wafers to each other. That is, the method for producing a laminate of the present invention preferably further includes, subsequent to said step, a step of polishing a surface of the polyimide resin layer, the surface being opposite to a surface that is in contact with the support substrate.

The polishing method used in the present step is not particularly limited, but examples of preferable polishing method used in the present step include mechanical polishing, chemical polishing, and chemical mechanical polishing. From the viewpoint of improving flatness, chemical mechanical polishing is more preferable, and a combination of two or more thereof may be performed.

As a slurry used for chemical mechanical polishing (CMP), it is preferable to use a slurry in which particles having an appropriate particle size are dispersed according to required flatness degree. The slurry is preferably an aqueous dispersion of alumina, silica, or silicon carbide, more preferably an alumina slurry, and two or more of these may be used. It is more preferable to perform rough polishing with a slurry having a large particle size and to perform finish polishing with a slurry having a small particle size, and the polishing step may be divided into three or more stages.

The polishing pad may be appropriately selected according to the size, application, slurry, and the like of the laminate, but a urethane pad or the like is preferable.

For the mechanical polishing, polishing paper, a polishing belt, a grinder, or the like can be used. As the abrasive grains fixed to abrasive paper or the like, diamond, alumina, or the like is preferable.

### (Step of laminating inorganic layer)

The laminate of the present invention includes a polyimide resin layer on a support substrate including a step, but it may further include an inorganic layer on the polyimide resin layer. When the laminate of the present invention includes an inorganic layer, the method preferably further includes a step of laminating the inorganic layer after the step of obtaining the polyimide resin layer or the step of polishing.

The inorganic layer may be laminated by any methods, but it is preferably laminated by sputtering, CVD deposition, or vacuum vapor deposition.

### Examples

Hereinafter, the present invention will be specifically described with reference to Examples. However, the present invention is not limited in any way by these Examples.

### <Physical properties of polyimide resin>

### (1) Glass transition temperature of polyimide resin

The glass transition temperature of the polyimide resin constituting the polyimide resin layer in the laminates of Examples and Comparative Examples was measured as follows.

The polyamic acid varnish obtained in (Production of polyamic acid varnish) of each of Examples and Comparative Examples was applied onto a support substrate (4 inch silicon wafer), held on a hot plate at 100°C for 10 minutes, then heated to 400°C at a temperature increasing rate of 5°C/min in a nitrogen atmosphere in a hot air dryer, and heated at 400°C for 30 minutes to evaporate the solvent and thermally imidize the solvent, whereby a polyimide film having a thickness of 10 µm was obtained.

For the obtained polyimide film, using a thermomechanical analyzer "TMA 7100C" manufactured by Hitachi High-Tech Science Corporation, the temperature was raised from 40°C to 500°C under the conditions of a sample size of 4 mm × 20 mm, a load of 50 mN, and a temperature increasing rate of 10°C/min in a tensile mode to perform TMA measurement, and a point where an inflection point of elongation was observed by extrapolation was defined as a glass transition temperature (Tg). The larger the value of the glass transition temperature (Tg), the better the thermal resistance.

The glass transition temperature of the polyimide resin is presented in Table 1.

### <Process evaluation>

The process evaluation for the laminate was performed by the following method.

### (1) Adhesion

The adhesion of the laminates (support substrate including a step/polyimide resin layer) obtained in Examples and Comparative Examples was measured according to ASTM D3359. Specifically, a cross-cut test was performed under the following conditions to evaluate adhesion.

### (Adhesion after post baking)

Using a cutter guide and a cutter knife, 10 × 10 (100 squares (size of one square: 1 mm × 1 mm)) cuts reaching the support substrate were made on the polyimide resin layer in each of the laminates (support substrate including a step/polyimide resin layer) obtained in Examples and Comparative Examples. A tape (Cellotape (trade name), CT-24 manufactured by NICHIBAN Co., Ltd.) was flatly attached to the grid portion (cross-cut portion) formed by the cuts in such a manner that air bubbles or the like did not enter the range of the grid portion + 20 mm. The attached tape was peeled off within 0.5 to 1 second, the state of the grid portion was observed, and the number of squares remaining without being peeled off was counted. The larger the number of remaining squares, the higher the adhesion. The evaluation criteria were as follows.
A: The number of remaining squares is 80 or more out of 100 squares.
B: The number of remaining squares is 50 or more and less than 80 squares out of 100 squares.
D: The number of remaining squares is less than 50 squares out of 100 squares.

### (Adhesion after annealing)

Each of the laminates (support substrate including a step/polyimide resin layer) obtained in Examples and Comparative Examples was further heated and annealed at 400°C for 3 hours.

Using a cutter guide and a cutter knife, 10 × 10 (100 squares (size of one square: 1 mm × 1 mm)) cuts reaching the support substrate were made on the polyimide resin layer in the laminate after annealing. A tape (Cellotape (trade name), CT-24 manufactured by NICHIBAN Co., Ltd.) was flatly attached to the grid portion (cross-cut portion) formed by the cuts in such a manner that air bubbles or the like did not enter the range of the grid portion + 20 mm. The attached tape was peeled off within 0.5 to 1 second, the state of the grid portion was observed, and the number of squares remaining without being peeled off was counted. The larger the number of remaining squares, the higher the adhesion. The evaluation criteria were as follows.
A: The number of remaining squares is 80 or more out of 100 squares.
B: The number of remaining squares is 50 or more and less than 80 squares out of 100 squares.
D: The number of remaining squares is less than 50 squares out of 100 squares.

### (2) Embedding property

The step portion of each of the laminates (support substrate including a step/polyimide resin layer) obtained in Examples and Comparative Examples was cleaved, and a corner portion of a lower portion of the step of the laminate was observed with a scanning electron microscope (SU8000, manufactured by Hitachi High-Tech Corporation) at a magnification of 5000 to evaluate embedding properties of the resin in the support substrate including a step. Evaluation was performed according to the following criteria.
A: No space is found between the support substrate and the resin.
D: A space is observed between the support substrate and the resin.

### (3) Flatness

The polyimide resin layer side of each of the laminates (support substrate including a step/polyimide resin layer) obtained in Examples and Comparative Examples was polished by any one of the following three types of methods. After polishing, the step portion of the laminate was cleaved, the section was enlarged using a digital microscope VHX-7000 (manufactured by KEYENCE CORPORATION), and the difference in height between the thinnest portion of the polyimide resin layer formed on the lower portion of the step of the support substrate of the polyimide resin layer and the thickest portion of the polyimide resin layer formed on the upper portion of the step of the support substrate was measured and evaluated according to the following criteria. The "height" is a length from the plane formed by the surface of the lower portion of the step of the support substrate to the surface of the polyimide resin layer in a vertical direction. The smaller the difference in height is, the better the flatness is. A polyimide resin layer having poor adhesion to the support substrate that peeled off during polishing was defined as D.
A: The difference in height between the lower portion of the step and the upper portion of the step is 1.0 µm or less.
B: The difference in height between the lower portion of the step and the upper portion of the step is more than 1.0 µm and 2.0 µm or less.
C: The difference in height between the lower portion of the step and the upper portion of the step is more than 2.0 µm.
D: Peeled during polishing, and polishing was not able to be performed

### (Polishing method 1: Mechanical polishing)

In the polyimide resin layer, polishing paper was used to polish the polyimide resin. Specifically, the polyimide resin layer was polished under the conditions of "Polishing paper #2500 (6 µm), load 100 g, 2 minutes", "Diamond film (2 µm), load 100 g, 2 minutes", and "Diamond film (0.5 µm), load 100 g, 2 minutes".

### (Polishing method 2: CMP1)

In the polyimide resin layer, alumina slurry was used to polish the polyimide resin. Specifically, the polyimide resin layer was polished under the conditions of "alumina slurry with particle size of 1.5 µm, polishing pressure 5.3 psi, rotation speed 100 rpm, 4 minutes 30 seconds".

### (Polishing method 3: CMP2)

In the polyimide resin layer, alumina slurry was used to polish the polyimide resin. Specifically, the polyimide resin layer was polished under the conditions of "alumina slurry with particle size of 1.5 µm, polishing pressure 5.3 psi, rotation speed 100 rpm, 1 minute 30 seconds" and "silica slurry with particle size of 100 nm, polishing pressure 5.3 psi, rotation speed 100 rpm, 5 minutes".

### (Polishing method 4: Mechanical polishing/grinder)

In the polyimide resin layer, a semiconductor wafer grinding apparatus was used to polish the polyimide resin. Specifically, a blade having a roughness number #6000 was attached, and the polyimide resin layer was polished at a polishing speed of 0.1 µm/s, a spindle rotation speed of 2000 rpm, and a table rotation speed of 100 rpm.

### (4) Inorganic layer-deposition property (evaluation of layer-deposition property)

SiN of 1000 Å was deposited as an inorganic layer by sputtering on the polyimide resin layer of each of the laminates (support substrate including a step/polyimide resin layer) obtained in Examples and Comparative Examples.

The presence or absence of cracks in the inorganic layer of the laminate after layer deposition was visually evaluated. Those in which no cracks were observed as a result of the evaluation without using a microscope were further evaluated with a microscope (magnification: 100 times). The smaller the size of the crack, the less the defects at the time of layer deposition, the higher the thermal resistance, and the better the properties. A laminate with no cracks has no defect at the time of layer deposition, thermal resistance is higher, and the properties are better.
A: No cracks are observed in the inorganic layer even when the inorganic layer is magnified 100 times with a microscope.
D: No cracks are visually observed in the inorganic layer, but cracks are observed in the inorganic layer when the inorganic layer is magnified 100 times with a microscope.
E: Cracks are visually observed in the inorganic layer.

### (5) Annealing resistance (evaluation of thermal resistance)

SiN of 1000 Å was deposited as an inorganic layer by sputtering on the polyimide resin layer of each of the laminates (support substrate including a step/polyimide resin layer/inorganic layer) obtained in Examples and Comparative Examples. The obtained laminate (support substrate including a step/polyimide resin layer/inorganic layer) was heated and annealed at 400°C for 3 hours.

The presence or absence of cracks in the inorganic layer of the laminate (support substrate/polyimide resin/inorganic layer) was visually evaluated. The evaluation was made visually and microscopically. Those in which no cracks were observed as a result of the evaluation without using a microscope were further evaluated with a microscope (magnification: 100 times). The smaller the size of the crack, the less the defects at the time of layer deposition, the higher the thermal resistance, and the better the properties. A laminate with no cracks has no defect at the time of layer deposition, thermal resistance is higher, and the properties are better.
A: No cracks are observed in the inorganic layer even when the inorganic layer is magnified 100 times with a microscope.
D: No cracks are visually observed in the inorganic layer, but cracks are observed in the inorganic layer when the inorganic layer is magnified 100 times with a microscope.
E: Cracks are visually observed in the inorganic layer.

The tetracarboxylic acid component and diamine component used in Examples and Comparative Examples, and the abbreviations thereof are as follows.

### <Tetracarboxylic acid component>

ODPA: 4,4'-oxydiphthalic anhydride (manufactured by MANAC Incorporated, a compound represented by Formula (a1))

s-BPDA: 3,3',4,4'-biphenyltetracarboxylic dianhydride (manufactured by Mitsubishi Chemical Corporation, a compound represented by Formula (a2))

DSDA: 3,3',4,4'-diphenylsulfonetetracarboxylic dianhydride (manufactured by ChinaTech Chemical (Tianjin) Co., Ltd., a compound represented by Formula (a3))

PMDA: Pyromellitic dianhydride (manufactured by Tokyo Chemical Industry Co., Ltd.)

### <Diamine component>

4-BAAB: 4-aminophenyl-4-aminobenzoate (manufactured by Nipponjunryo Chemicals Co., Ltd., a compound represented by Formula (b1))

APTP: bis(4-aminophenyl)terephthalate (manufactured by Tokyo Chemical Industry Co., Ltd., a compound represented by Formula (b2))

PPD: p-phenylenediamine

Abbreviations of the solvents and catalysts used in Examples and Comparative Examples are as follows.

NMP: N-methyl-2-pyrrolidone (manufactured by Tokyo Pure Chemical Industries, Co., Ltd.)

GBL: γ-butyrolactone (manufactured by Mitsubishi Chemical Corporation)

### <Production of laminate (support substrate/polyimide resin layer)>

### Example 1

### (Production of polyamic acid varnish)

A 1 L five-neck round-bottom flask provided with a semilunar-shaped stirring blade made of stainless steel, a nitrogen inlet tube, a Dean-Stark apparatus equipped with a condenser, a thermometer, and an end cap made of glass was charged with 34.836 g (0.100 mol) of APTP and 294.927 g of NMP, the mixture was stirred at a rotational speed of 200 rpm in a nitrogen atmosphere with a system temperature of 50°C, and a solution was obtained.

To this solution, 15.511 g (0.050 mol) of ODPA, 14.711 g (0.050 mol) of s-BPDA, and 73.732 g of NMP were collectively charged, and stirred for 3 hours while being maintained at 50°C with a mantle heater, thereafter 108.429 g of NMP was charged, whereby a polyamic acid varnish having a solids content concentration of 12 mass% was obtained.

### (Production of polyimide resin layer and laminate)

Subsequently, the obtained polyamic acid varnish was applied onto a support substrate including a step (4-inch silicon wafer (step: 10 µm, distance of the lower portion of the step: 280 µm) and 4-inch silicon wafer on which SiN is deposited (step: 10 µm, distance of the lower portion of the step: 280 µm)), and held on a hot plate at 80°C for 20 minutes. Thereafter, the temperature was raised to 400°C at a temperature increasing rate of 5°C/min in a nitrogen atmosphere in a hot air dryer. Heating was performed at 400°C for 60 minutes, the solvent was evaporated, thermal imidization was performed to form a polyimide resin layer on the support substrate, whereby a laminate was obtained. The evaluation results of the obtained laminates are presented in Table 1.

### Example 2

A polyamic acid varnish having a solids content concentration of 5 mass% was obtained, a polyimide resin layer was formed on a support substrate, and a laminate was obtained in the same manner as in Example 1, except that ODPA and s-BPDA were changed to 294.22 g (0.100 mol) of s-BPDA, and the amount of NMP to be diluted was changed. The evaluation results of the obtained laminates are presented in Table 1.

### Example 3

A polyamic acid varnish having a solids content concentration of 12 mass% was obtained, a polyimide resin layer was formed on a support substrate, and a laminate was obtained in the same manner as in Example 1, except that ODPA and s-BPDA were changed to 35.828 g (0.100 mol) of DSDA, APTP was changed to 22.825 g (0.100 mol) of 4-BAAB, and the amount of NMP to be diluted was changed. The evaluation results of the obtained laminates are presented in Table 1.

### Example 4

A polyamic acid varnish having a solids content concentration of 12 mass% was obtained, a polyimide resin layer was formed on a support substrate, and a laminate was obtained in the same manner as in Example 1, except that ODPA and s-BPDA were changed to 25.080 g (0.070 mol) of DSDA and 6.544 g (0.030 mol) of PMDA, APTP was changed to 22.825 g (0.100 mol) of 4-BAAB, and the amount of NMP to be diluted was changed. The evaluation results of the obtained laminates are presented in Table 1.

### Example 5

A polyamic acid varnish having a solids content concentration of 12 mass% was obtained, a polyimide resin layer was formed on a support substrate, and a laminate was obtained in the same manner as in Example 1, except that ODPA and s-BPDA were changed to 17.914 g (0.050 mol) of DSDA and 10.906 g (0.050 mol) of PMDA, APTP was changed to 22.825 g (0.100 mol) of 4-BAAB, and the amount of NMP to be diluted was changed. The evaluation results of the obtained laminates are presented in Table 1.

### Comparative Example 1

A polyamic acid varnish having a solids content concentration of 12 mass% was obtained, a polyimide resin layer was formed on a support substrate, and a laminate was obtained in the same manner as in Example 1, except that ODPA and s-BPDA were changed to 294.22 g (0.100 mol) of s-BPDA, and APTP was changed to 10.814 g (0.100 mol) of PPD. The evaluation results of the obtained laminates are presented in Table 1.

### [Table 1]

**Table 1**

| | | | | Example 1 | | Example 2 | Example 3 | Example 4 | Example 5 | | | Comparative Example 1 |
|---|---|---|---|---|---|---|---|---|---|---|---|---|
| Polyimide resin (*1) | Tetracarboxylic acid component | ODPA | Formula (a1) | 50 | | - | - | - | - | | | - |
| | | s-BPDA | Formula (a2) | 50 | | 100 | - | - | - | | | 100 |
| | | DSDA | Formula (a3) | - | | - | 100 | 70 | 50 | | | - |
| | | PMDA | - | - | | - | - | 30 | 50 | | | - |
| | Diamine component | 4-BAAB | Formula (b1) | - | | - | 100 | 100 | 100 | | | - |
| | | APTP | Formula (b2) | 100 | | 100 | - | - | - | | | - |
| | | PPD | - | - | | - | - | - | - | | | 100 |
| | Glass transition temperature (°C) | | | 445 | | 434 | 439 | 423 | 424 | | | 449 |
| | Adhesion (cross-cut test) | After post baking | Silicon wafer | A | | A | A | A | A | | | D |
| | | | SiN-formed silicon wafer | A | | A | A | A | A | | | D |
| | | After annealing | Silicon wafer | A | | A | A | A | A | | | D |
| | | | SiN-formed silicon wafer | A | | A | A | A | A | | | D |
| Process evaluation | Embedding property | | - | A | | A | A | A | A | | | D |
| | Flatness | Polishing method | - | Mechanical polishing | CMP1 | Mechanical polishing | CMP2 | CMP2 | Mechanical polishing | CMP2 | Grinder | Mechanical polishing |
| | | Evaluation result | - | A | A | A | A | A | A | A | B | D |
| | Inorganic layer-deposition properties | | - | A | | A | A | A | A | | | A |
| | Annealing resistance | | - | A | | A | A | A | A | | | A |

| | | | | | | | | | | | | |
|---|---|---|---|---|---|---|---|---|---|---|---|---|
| (*1) The number in the column of Polyimide resin represents the mole ratio in each component. | | | | | | | | | | | | |

As presented in Table 1, it can be seen that the laminates of Examples are excellent in thermal resistance, adhesion, step embedding properties, and flatness. Thus, the laminate of the present invention has the properties as described above and is therefore useful as a laminate in the semiconductor process.

## Claims

1. A laminate, comprising a support substrate and a polyimide resin layer on the support substrate, the support substrate including a step, wherein a polyimide resin constituting the polyimide resin layer has a structural unit of General Formula (1) set forth below, and a glass transition temperature of the polyimide resin is 300°C or higher:

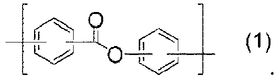

2. The laminate according to claim 1, wherein, on the polyimide resin layer, an inorganic layer containing silicon is provided.

3. The laminate according to claim 1 or 2, wherein a height of the step of the support substrate is from 0.1 to 50 µm.

4. The laminate according to any one of claims 1 to 3, wherein a film thickness of the polyimide resin layer is from 0.5 to 300 µm.

5. The laminate according to any one of claims 2 to 4, wherein the inorganic layer comprises a silicon oxide or a silicon nitride.

6. The laminate according to any one of claims 2 to 5, wherein a thickness of the inorganic layer is from 1 to 1,000 nm.

7. The laminate according to any one of claims 1 to 6, wherein the support substrate comprises silicon, silicon carbide, gallium nitride, gallium oxide, aluminum nitride, or diamond.

8. A method for producing a laminate, the method comprising a step of obtaining a polyimide resin layer by applying a varnish of a polyimide resin or a varnish of a polyimide resin precursor onto a support substrate including a step and heating, wherein the polyimide resin or the polyimide resin precursor has a structural unit of General Formula (1) set forth below:

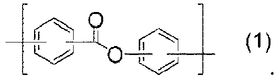

9. The method for producing a laminate according to claim 8, further comprising a step of polishing a surface of the polyimide resin layer, the surface being opposite to a surface that is in contact with the support substrate.

10. The method for producing a laminate according to claim 8 or 9, further comprising a step of laminating, on the laminate, an inorganic layer.
